# EUROPEAN PATENT SPECIFICATION

(11) **EP 2 071 051 B1**
(45) Date of publication and mention of the grant of the patent: **31.08.2016**
(21) Application number: 07828671.3
(22) Date of filing: 28.09.2007
(51) Int. Cl.: C23C 14/24, C23C 14/04, B05C 1/08, B41F 7/26, C23C 14/56, B41F 31/00, B41F 31/15

(54) **TAKEUP TYPE VACUUM FILMING APPARATUS**
VAKUUMFOLIENVORRICHTUNG MIT AUFNAHME
APPAREIL DE FILMAGE SOUS VIDE DU TYPE AVEC TENDEUR

(30) Priority: 06.10.2006 JP 2006275151
(43) Date of publication of application: 17.06.2009
(73) Proprietor: ULVAC, INC., Chigasaki-shi, Kanagawa 2538543 (JP)
(72) Inventor: HAYASHI, Nobuhiro, Chigasaki-shi Kanagawa 2538543 (JP); FUJII, Tomoharu, Chigasaki-shi Kanagawa 2538543 (JP); TADA, Isao, Chigasaki-shi Kanagawa 2538543 (JP); NAKATSUKA, Atsushi, Chigasaki-shi Kanagawa 2538543 (JP)
(74) Representative: D Young & Co LLP
(86) International application number: PCT/JP2007/068929
(87) International publication number: WO 2008/044489

(56) References cited:
- EP-A1- 0 447 550
- EP-A1- 1 172 208
- WO-A1-98/21045
- JP-A- 02 263 419
- JP-A- 07 228 068
- JP-A- 10 081 958
- JP-A- 2000 144 375
- JP-A- 2000 144 375
- JP-A- 2006 225 710
- US-A- 4 029 008

## Description

### Technical Field

The present invention relates to a roll-to-roll vacuum deposition apparatus preferably employed to produce, for example, a film capacitor.

### Background Art

From the past, there has been used to produce a film capacitor, a roll-to-roll vacuum vapor deposition apparatus for depositing, while causing an insulative film made of plastic or the like successively paid out from a payout roller, metal onto a surface of the film to form a deposited metal layer thereon, and taking up the film by a take-up roller.

Meanwhile, there has been known as a film capacitor of this type, a self-protection type capacitor in which a deposited metal layer formed on the surface of the film is divided into a plurality of capacitor chips, and the adjacent capacitor chips are connected to each other via narrow connecting portions, the capacitor chips and the connecting portions being formed of the same deposited layer. The film capacitor of this type causes, when an insulation breakdown occurs at part thereof, to melt some of the connecting portions above (fuse function), to thereby capable of minimizing an insulation breakdown area in a unit of chip.

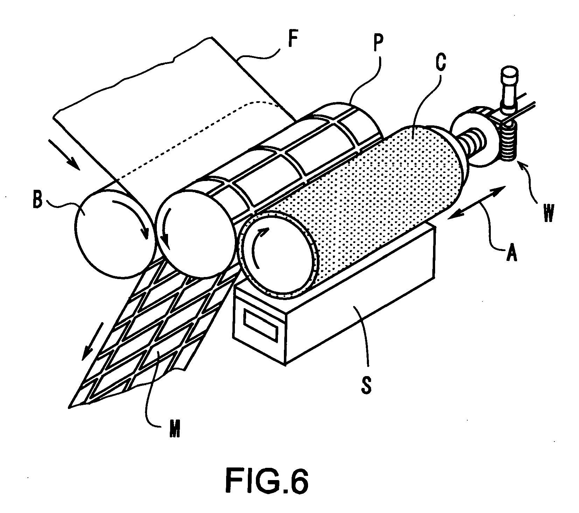

In producing such self-protection type capacitor in the above-described roll-to-roll vacuum deposition apparatus, a mask forming unit for forming a mask pattern defining a metal layer deposition area on a deposition surface of the film, is disposed between the payout roller and a evaporation source. For example, as shown in Fig. 6, there is known a mask forming unit for continuously transferring, while delivering a film F sandwiched between a printing roller (plate cylinder) P and a backup roller (impression cylinder) B, oil for forming a mask pattern M supplied from an oil supply source S to the printing roller P via an oil condensing roller C, from the printing roller P to a deposition surface of the film F to form the mask pattern M (see Patent Document 1 below).

Here, the oil condensing roller C functions to condense oil vapor ejected from the oil supply source S onto a circumferential surface thereof to hold the oil adhered thereonto. Thus, the oil condensing roller C is heated by condensing heat of the oil vapor. Meanwhile, as the temperature of the front surface increases, condensation efficiency deteriorates, to thereby reduce the oil adhesion amount. So, it is required to cool the oil condensing roller C to a predetermined temperature or lower. Further, a contact area of the printing roller P with respect to the oil condensing roller C is fixed due to a pattern form of the mask pattern M, whereby transfer accuracy of the oil with respect to the printing roller P deteriorates, and pattern accuracy of the mask pattern M may deteriorate.

To solve such problem, the conventional mask forming unit of Fig. 6 is structured such that a circulation mechanism for a cooling medium is provided to the oil condensing roller C to forcibly cool the oil condensing roller C, and includes a rocking mechanism W for periodically rocking the oil condensing roller C in an axial direction thereof (arrow A direction), in order to prevent deterioration of condensation and adhesion efficiency of the oil and the transfer accuracy of the oil with respect to the printing roller P.

Patent Document 1: Japanese Patent Application Laid-open No. 2000-144375

### Disclosure of the Invention

### Problem to be solved by the Invention

However, since the roll-to-roll vacuum deposition apparatus having the conventional mask forming unit of Fig. 6 is structured such that the oil condensing roller C includes the forced cooling mechanism and the rocking mechanism, the structure of the oil condensing roller C becomes complicated, which leads to a problem in that assembling workability deteriorates. Further, since it is necessary to circulate cooling water to supply the cooling water to a movable portion under a vacuum pressure, a special joint should be provided, which leads to increase in cost.

The present invention has been made in view of the above-mentioned problem, and it is therefore an object of the invention to provide a roll-to-roll vacuum deposition apparatus capable of simplifying a structure and improving assembling property of the oil condensing roller, while preventing deterioration of the condensation and adhesion efficiency of the oil and transfer efficiency of the oil to the printing roller. Means for solving the Problem

To solve the problem above, a roll-to-roll vacuum deposition apparatus according to the present invention has a mask forming means for forming a mask pattern defining a deposition area of a deposition material on a film. The mask forming means includes a supply source of oil for forming the mask pattern, a first roller for holding the oil supplied from the supply source at an outer circumference, a second roller for transferring the oil to a deposition surface of the film as the mask pattern, and a third roller disposed between the first roller and the second roller, for transferring the oil from the first roller to the second roller. The mask forming means includes a cooling mechanism for cooling the first roller, and a rocking mechanism for periodically rocking the third roller in an axial direction with respect to the first and second rollers.

In the present invention, the first roller corresponds to an oil condensing roller for condensing oil vapor to be adhered thereto. The second roller corresponds to a printing roller for printing the oil pattern on the deposition surface of the film. In the present invention, between the first roller and the second roller, a transfer roller for transferring the oil from the first roller to the second roller is disposed as the third roller. Further, the cooling mechanism is provided to the first roller and the rocking mechanism is provided to the third roller, whereby deterioration of condensation and adhesion efficiency of the oil at the first roller and transfer efficiency of the oil to the second roller can be prevented.

So, according to the present invention, the oil condensing roller is structured so as not to rock in the axial direction, whereby the cooling mechanism can easily be provided to the oil condensing roller, the structure of the oil condensing roller having the cooling mechanism is simplified, assembling property can be improved, and manufacturing cost can be lower.

In general, a front layer of the oil condensing roller is made of a relatively hard ceramic material, and has microscopic asperities on the front surface. Meanwhile, a front surface of the printing roller is formed with a printing plate made of a plastic material such as rubber, resin, or the like. So, in the above-described conventional mask forming unit, when the oil condensing roller is rocked in the axial direction, a front layer of the printing roller in contact therewith is likely to be worn. As a result, transferring accuracy of the mask pattern with respect to the film deteriorates, and replacing frequency of the printing roller increases, whereby transferring accuracy of the mask pattern cannot stably be maintained for long.

So, in the present invention, in the above-described structure in which the third roller (transfer roller) is disposed between the first roller (oil condensing roller) and the second roller (printing roller), a front layer of the third roller is made of a material softer than that of the first roller (for example, a soft resin material such as urethane rubber) to thereby reduce abrasion of the front layer of the second roller, due to relative displacement of the third roller and the second roller. Accordingly, longevity of the second roller is extended, and high-accuracy transfer and formation of the mask pattern with respect to the film can stably be performed for long. More preferably, the front layer of the third roller is made of a material softer than that of the front layer of the second roller. As a result, the second roller can be protected for a longer period of time.

### Effect of the Invention

As described above, according to the roll-to-roll vacuum deposition apparatus of the present invention, the transfer roller is provided as the third roller between the oil condensing roller and the printing roller, and the cooling mechanism for cooling the oil condensing roller and the rocking mechanism for periodically rocking the transfer roller in the axial direction are provided. So, deterioration of the condensation and adhesion efficiency of the oil and the transfer efficiency of the oil to the printing roller can be prevented, the structure of the oil condensing roller can be simplified, and the assembling property can be improved. Further, deterioration of the transferring accuracy of the mask pattern from the printing roller to the film can be prevented.

Further, the front layer of the transfer roller is made of the material softer than that of the front layer of the oil condensing roller to thereby reduce abrasion of the front layer of the printing roller, due to relative displacement of the transfer roller and the printing roller. Accordingly, longevity of the printing roller is extended, and high-accuracy transfer and formation of the mask pattern with respect to the film can stably be performed for long.

### Brief Description of Drawings

[Fig. 1] A schematic structural diagram of a roll-to-roll vacuum vapor deposition apparatus as a roll-to-roll vacuum deposition apparatus according to an embodiment of the present invention.
[Figs. 2] Diagrams showing an example of a mask pattern formed by a mask forming unit of the roll-to-roll vacuum deposition apparatus of Fig. 1, in which Fig. 2A shows a state where a metal layer is yet to be deposited, and Fig. 2B shows a state where the metal layer is deposited.
[Fig. 3] A schematic side diagram showing a structure of the mask forming unit of the roll-to-roll vacuum deposition apparatus of Fig. 1.
[Fig. 4] A schematic plan diagram showing the mask forming unit of Fig. 3.
[Figs. 5] Diagrams for explaining structural examples of a rocking mechanism of a transferring roller of the mask forming unit of Fig. 3.
[Fig. 6] A schematic perspective diagram showing a structure of a mask forming unit of a conventional roll-to-roll vacuum deposition apparatus.

### Description of Reference Numerals

10 roll-to-roll vacuum vapor deposition apparatus
11 vacuum chamber
12 material film
13 payout roller
14 can roller (cooling roller)
15 take-up roller
16 evaporation source
20 mask forming unit
21 backup roller
25 oil pattern
26 metal layer
31 oil condensing roller
32 transfer roller
33 printing roller

### Best Mode for Carrying Out the Invention

Hereinafter, an embodiment of the present invention will be described with reference to the drawings. In this embodiment, descriptions will be given on an example where the present invention is applied to a roll-to-roll vacuum vapor deposition apparatus as a roll-to-roll vacuum deposition apparatus.

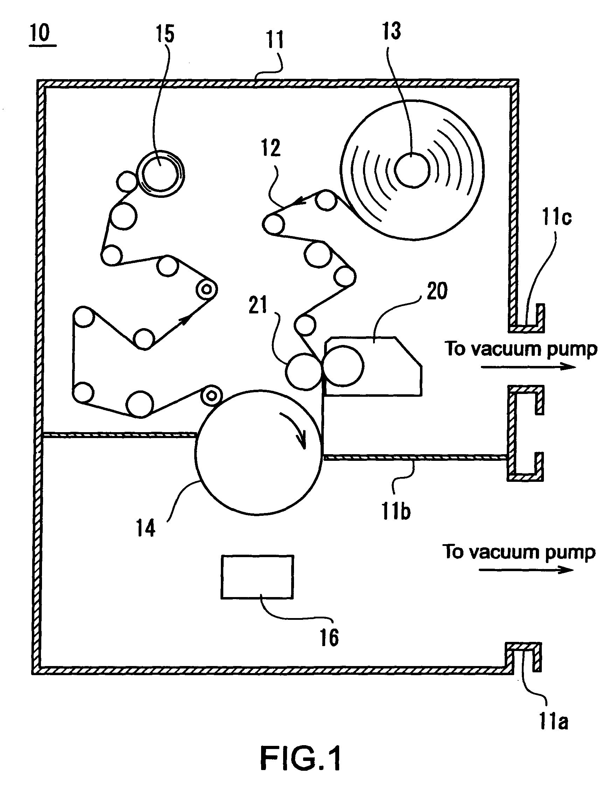

Fig. 1 is a schematic structural diagram of a roll-to-roll vacuum vapor deposition apparatus 10 according to the embodiment of the present invention. The roll-to-roll vacuum vapor deposition apparatus 10 of this embodiment includes a vacuum chamber 11, a payout roller 13 for a film 12, a cooling can roller 14, a take-up roller 15 for the film 12, and an evaporation source 16 of an evaporation material.

The vacuum chamber 11 is connected to a vacuum exhaust system such as a vacuum pump (not shown) via pipe connection portions 11a and 11c, and is exhausted to reduce a pressure inside to a predetermined vacuum degree. An internal space of the vacuum chamber 11 is sectioned by a partition plate 11b into a room in which the payout roller 13, the take-up roller 15, and the like are disposed, and a room in which the evaporation source 16 is disposed.

The film 12 is constituted of a long plastic film having an insulation property and cut at a predetermined width. For example, an OPP (oriented polypropylene) film, a PET (polyethylene terephthalate) film, a PPS (polyphenylene sulfide) film, or the like is used. The film 12 is paid out from the payout roller 13 and is taken up by the take-up roller 15 via a plurality of guide rollers and the can roller 14. It should be noted that although not shown, each of the payout roller 13 and the take-up roller 15 is provided with a rotary drive portion.

The can roller 14 is tubular and made of metal such as iron. Inside, the can roller 14 has a cooling mechanism such as a cooling medium circulation system, a rotary drive mechanism for rotationally driving the can roller 14, and the like. The film 12 is wound around a circumferential surface of the can roller 14 at a predetermined holding angle. The film 12 wound around the can roller 14 is deposited with, on a deposition surface on an outer surface side thereof, the evaporation material from the evaporation source 16 so as to form a deposited layer, and at the same time, is cooled by the can roller 14.

The payout roller 13, the can roller 14, the take-up roller 15, and the other guide rollers above constitute a "traveling means" of the present invention for causing the film 12 to travel inside the vacuum chamber 11.

The evaporation source 16 accommodates the evaporation material and has a mechanism for causing the evaporation material to evaporate by heating using a well-known technique such as resistance heating, induction heating, and electron beam heating. The evaporation source 16 is disposed below the can roller 14 and causes the vapor of the evaporation material to adhere onto the film 12 on the can roller 14 opposed thereto, to thus form the deposited layer. It should be noted that the evaporation source 16 corresponds to a "depositing means" of the present invention for depositing a deposition material onto the traveling film 12.

As the evaporation material, in addition to a metal element single body such as Al (aluminum), Co (cobalt), Cu (copper), Ni (nickel), and Ti (titanium), two or more metals such as Al-Zn (zinc), Cu-Zn, and Fe (iron)-Co, or a multi-component alloy is applicable. In addition, the number of evaporation source 16 is not limited to one, and a plurality of evaporation sources may be provided.

The roll-to-roll vacuum vapor deposition apparatus 10 of this embodiment further includes a mask forming unit 20. The mask forming unit 20 is provided at an upstream side of the evaporation source 16, that is, between the payout roller 13 and the evaporation source 16 (can roller 14). The mask forming unit 20 constitute a "mask forming means" of the present invention.

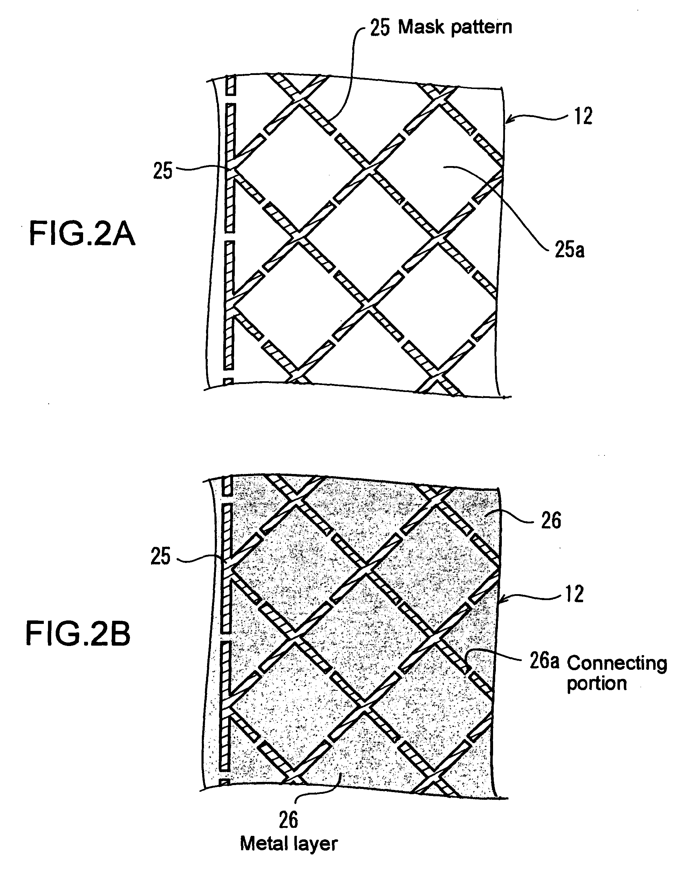

Figs. 2 each shows a deposition surface of the film 12. The mask forming unit 20 is structured so as to apply a mask pattern (oil pattern) 25 (hatched area of Fig. 2A, for example) onto approximately the entire surface of the deposition surface of the film 12. Metal is not deposited on the mask pattern 25 and no deposited layer is formed thereon. So, after the deposition, a metal layer 26 having such form that substantially rectangular metal patterns, obtained by applying the deposition material onto portions 25a free from the mask pattern 25, are connected at predetermined pitches via connecting portions 26a, is formed. It should be noted that the deposition form of the metal layer 26 is not limited to the above.

It should be noted that the metal layer 26 constitutes condenser chips, and the connecting portions 26a are structured to, when an insulation breakdown occurs at part of the electric layer 26, melt with Joule heat of the generated current. The metal layer 26 functions as a self-protection type film capacitor capable of minimizing an insulation breakdown area in a unit of chip.

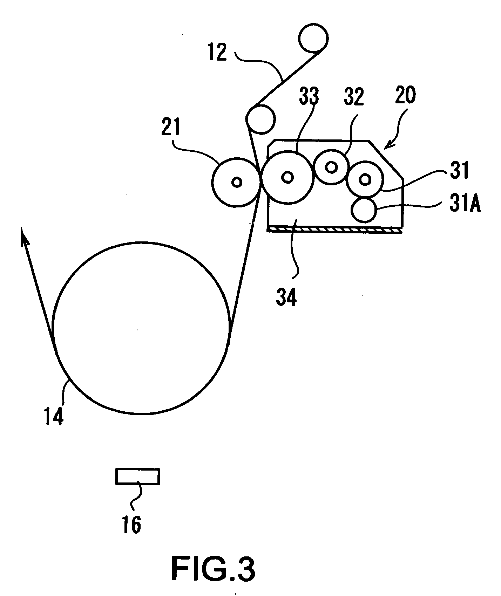

Fig. 3 is a schematic structural diagram of the mask forming unit 20. The mask forming unit 20 includes an oil ejection source 31A, an oil condensing roller (first roller) 31, a transfer roller (third roller) 32, a printing roller (second roller) 33, and a backup roller 21.

The oil condensing roller 31 condenses oil vapor ejected from the oil ejection source 31A onto a circumferential surface thereof to hold the adhered oil. A front layer of the oil condensing roller 31 is made
of a relatively hard ceramic material, and has microscopic asperities on the surface.

The transfer roller 32 transfers the oil adhered to the circumferential surface of the oil condensing roller 31 to the printing roller 33 by being brought into contact with the oil condensing roller 31. A front layer of the transfer roller 32 is made of a material softer than that of the front layer of the oil condensing roller 31, for example, a soft resin material such as urethane rubber.

The printing roller 33 includes, at an outer surface thereof, a printing plate for transferring the oil supplied from the transfer roller 33 to the deposition surface of the film 12 to form the mask pattern 25 thereon. The printing plate is made of rubber, resin, or the like. The backup roller 21 causes the film 12 to be brought into contact with the printing roller 33 with pressure by sandwiching the film 12 with the printing roller 33.

Both ends of shafts of the oil ejection source 31A, the oil condensing roller 31, the transfer roller 32, and the printing roller 33 are supported by a common frame body 34. The frame body 34 is integrally fixed to an inner wall surface of the vacuum chamber 11. The oil condensing roller 31, the transfer roller 32, and the printing roller 33 are structured to rotate in sync with and along with the traveling film 12. Alternatively, a driving unit for rotationally driving part of or all of those rollers is provided.

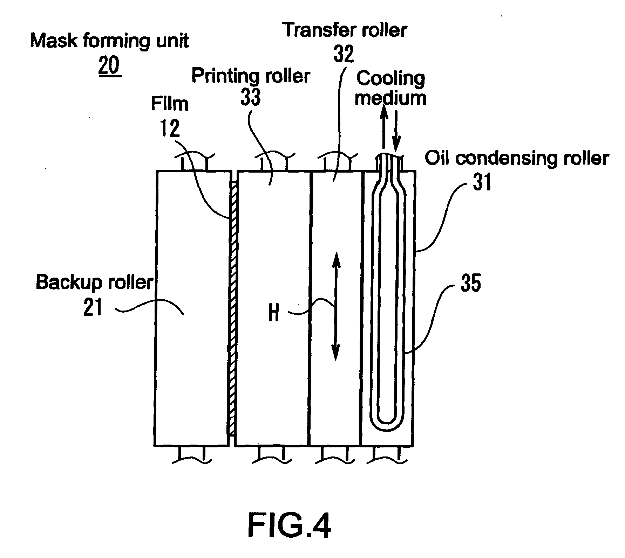

Fig. 4 is a schematic plan diagram of the mask forming unit 20. The mask forming unit 20 includes a cooling mechanism for cooling the oil condensing roller 31, and a rocking mechanism for periodically rocking the transfer roller 32 in an axial direction (arrow H) with respect to the oil condensing roller 31 and the printing roller 33.

The cooling mechanism of the oil condensing mechanism 31 is constituted by a circulation pipe 35 for circulating a cooling medium (cooling oil, cooling water, etc.) formed inside the oil condensing roller 31, and a circulation pump (not shown) for delivering the cooling medium to the circulation pipe 35. Accordingly, the temperature of the circumferential surface of the oil condensing roller 31 is kept at a predetermined temperature or lower, whereby deterioration of condensation and adhesion efficiency of the oil can be prevented. Specifically, in a case where the temperature of the oil vapor is 125°C to 135°C, the temperature of the cooling medium is set to 40°C to 50°C.

Meanwhile, the rocking mechanism is provided to prevent deterioration of the oil transferring accuracy from the transfer roller 32 to the printing roller 33. That is, in a case where the mask pattern has a continuous pattern in the traveling direction of the film 12 (circumferential direction of the printing roller 33), it is required to continuously and stably supply the oil to the patterned portion of the printing roller 33. So, by periodically rocking the transfer roller 32 in the axial direction, the contact area of the transfer roller 32 with respect to the printing roller 33 can be kept wider in the axial direction, and the oil of requisite amount can stably be transferred to the printing roller 33.

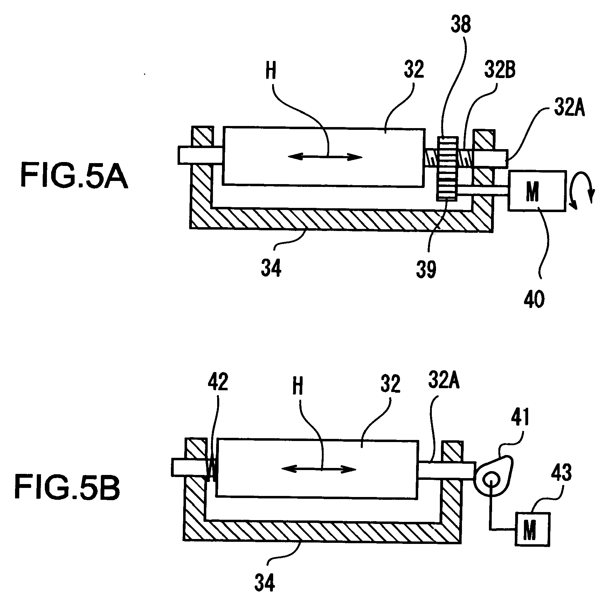

Figs. 5A and 5B show structural examples of the rocking mechanism of the transfer roller 32.

In the structural example of Fig. 5A, part of a shaft portion 32A of the transfer roller 32 is formed with a thread portion 32B. A first gear 38 engaged with the thread portion 32B and a second gear 39 meshed with an outer surface portion of the first gear 38 are provided. By periodically rotating the second gear 39 in clockwise and counterclockwise directions by the motor 40, the transfer roller 32 is rocked in the H direction.

Further, in the structural example of Fig. 5B, a cam 41 is disposed at one end side of the shaft portion 32A of the transfer roller 32, and a return spring 42 is provided at the other end side of the shaft portion 32A of the transfer roller 32. By rotationally driving the cam 41 by the motor 43, the transfer roller 32 is periodically rocked in the H direction.

Subsequently, an operation of the thus-structured roll-to-roll vacuum vapor deposition apparatus 10 of this embodiment will be described.

In the vacuum chamber 11 pressure-reduced to a predetermined vacuum pressure, the film 12 continuously paid out from the payout roller 13 is subjected to a mask forming step and a vapor deposition step, and is then continuously took up by the take-up roller 15.

In the mask forming step, the mask pattern 25 of Fig. 2A is printed on the deposition surface of the film 12 by the mask forming unit 20. The film 12 formed with the mask pattern 25 is wound around the can roller 14. It should be noted that, if necessary, the film 12 may be processed to improve an adhesion force with respect to the can roller 14, for example, the film 12 may be irradiated with charged particle radiation such as electron beam. Then, the evaporation material evaporated from the evaporation source 16 is deposited on the deposition surface of the film 12, whereby the metal layer 26 of Fig. 2B is formed. The film 12 deposited with the metal layer 26 is taken up by the take-up roller 15 via the guide rollers.

In this embodiment, the mask forming unit 20 is structured such that the transfer roller 32 is disposed between the oil condensing roller 31 and the printing roller 33, and includes the cooling mechanism for cooling the oil condensing roller 31 and the rocking mechanism for periodically rocking the transfer roller 32 in the axial direction. The cooling mechanism above prevents deterioration of condensation efficiency of the oil vapor by the oil condensing roller 31, and can stably secure the adhesion of the oil of requisite amount. Further, the rocking mechanism above can transfer and supply the oil of requisite amount to the printing roller 33, and can prevent deterioration of transferring accuracy of the mask pattern 25 with respect to the film 12.

Further, according to this embodiment, unlike the conventional mask forming unit of Fig. 6, the oil condensing roller 31 is not rocked in the axial direction, so, the cooling mechanism can easily be provided to the oil condensing roller 31, the structure of the oil condensing roller having the cooling mechanism is simplified, and assembling property can be improved.

Further, in this embodiment, the front layer of the transfer roller 32 is made of the material softer than that of the front layer of the oil condensing roller 31, so, compared to the structure of the conventional mask forming unit of Fig. 6, abrasion of the front layer of the printing roller 33 can be reduced. Accordingly, durability of the printing roller 33 is enhanced, and high-accuracy transfer and formation of the mask pattern 25 with respect to the film 12 can stably be performed for long. More preferably, the front layer of the transfer roller 33 is made of the material softer than that of the front layer of the printing roller 33. Accordingly, the printing roller 33 can be protected for a longer period of time.

The descriptions above have been given on the embodiment of the present invention. However, the present invention is of course not limited thereto and can be variously modified based on the technical idea of the present invention.

For example, the above embodiment has described the example of depositing a metal layer by applying the vacuum vapor deposition method that uses the evaporation source 16 as the depositing means. However, the present invention is not limited thereto, and other deposition methods for depositing a metal or nonmetal layer, such as a sputtering method or various CVD methods, are also applicable. Furthermore, a depositing means including a sputtering target can be appropriately adopted in accordance with those deposition methods.

It should be noted that a plurality of transfer rollers 32 may be employed, and at least one of the plurality of rollers may be rocked. Alternatively, among the plurality of rollers, a roller in contact with the printing roller 33 may be made of a material softer than that of the front layer of the printing roller 33.

## Claims

1. A roll-to-roll vacuum deposition apparatus including a vacuum chamber, a traveling means for causing a film to travel inside the vacuum chamber, a depositing source for depositing a deposition material onto the traveling film to form a deposited layer, and a mask forming unit disposed at an upstream side of the depositing source, for forming a mask pattern defining a deposition area of the deposition material on the film,
wherein the mask forming unit includes
a supply source for heating and evaporating oil for forming the mask pattern,
a first roller for condensing oil vapour supplied from the supply source to hold the oil at an outer circumference, the first roller having a front layer formed of a ceramic material having mircoscopic asperities on a surface thereof,
a second roller for transferring the oil to a deposition surface of the film as the mask pattern, the second roller having , at an outer surface thereof, a printing plate made of rubber or resin, and
a third roller disposed between the first roller and the second roller, for transferring the oil from the first roller to the second roller, the third roller having a front layer made of a resin material softer than the front layer of the first roller,
a cooling mechanism for cooling the first roller by circulating a cooling medium in the first roller, and
a rocking mechanism for periodically rocking the third roller in an axial direction with respect to the first and second rollers.

## Patentansprüche

1. Walze-zu-Walze-Vakuumabscheidungsvorrichtung, aufweisend eine Vakuumkammer, eine Fahrvorrichtung, um zu bewirken, dass eine Folie innerhalb der Vakuumkammer fährt, eine Abscheidequelle zum Abscheiden eines Abscheidungsmaterials auf die fahrende Folie zum Bilden einer abgeschiedenen Schicht und eine Maskenbildungseinheit, die auf der stromaufwärtigen Seite der Abscheidequelle angeordnet ist, um ein Maskenmuster zu bilden, das einen Abscheidungsbereich des Abscheidungsmaterials auf dem Film definiert, wobei die Maskenbildungseinheit aufweist:
eine Zufuhrquelle zum Erwärmen und Verdampfen von Öl zum Bilden des Maskenmusters,
eine erste Walze zum Kondensieren von Öldampf, der aus der Zufuhrquelle zugeführt wird, um das Öl an einem Außenumfang zu halten, wobei die erste Walze eine vordere Schicht aufweist, die aus keramischem Material mit mikroskopischen Unebenheiten auf einer Oberfläche davon ausgebildet ist,
eine zweite Walze zum Übertragen des Öls auf eine Abscheidungsoberfläche des Films als Maskenmuster, wobei die zweite Walze an einer äußeren Oberfläche davon eine Druckplatte aus Katuschuk oder Harz aufweist, und
eine dritte Walze, die zwischen der ersten Walze und der zweiten Walze zum Übertragen des Öls von der ersten Walze zur zweiten Walze angeordnet ist, wobei die dritte Walze eine vordere Schicht aus einem Harzmaterial aufweist, die weicher als die vordere Schicht der ersten Walze ist,
einen Kühlmechanismus zum Kühlen der ersten Walze durch Zirkulieren des Kühlmediums in der ersten Walze, und
einen Schwingmechanismus zum periodischen Schwingen der dritten Walze in eine axiale Richtung in Bezug auf die erste und zweite Walze.

## Revendications

1. Appareil de dépôt sous vide rouleau à rouleau comprenant une chambre à vide, un moyen de déplacement servant à amener un film à se déplacer à l'intérieur de la chambre à vide, une source de dépôt servant à déposer un matériau de dépôt sur le film en déplacement afin de former une couche déposée, et une unité de formation de masque disposée au niveau d'un côté amont de la source de dépôt, servant à former un motif de masque définissant une région de dépôt du matériau de dépôt sur le film,
l'unité de formation de masque comprenant une source d'alimentation servant à chauffer et à évaporer de l'huile afin de former le motif de masque,
un premier rouleau servant à condenser la vapeur d'huile provenant de la source d'alimentation afin de maintenir l'huile au niveau d'une circonférence extérieure, le premier rouleau comportant une couche avant constituée d'un matériau céramique comportant des aspérités microscopiques sur une surface de celle-ci,
un deuxième rouleau servant à transférer l'huile à une surface de dépôt du film en tant que motif de masque, le deuxième rouleau comportant, au niveau d'une surface extérieure de celui-ci, une plaque d'impression constituée de caoutchouc ou de résine, et
un troisième rouleau disposé entre le premier rouleau et le deuxième rouleau, servant à transférer l'huile du premier rouleau au deuxième rouleau, le troisième rouleau comportant une couche avant constituée d'un matériau résineux plus souple que la couche avant du premier rouleau,
un mécanisme de refroidissement servant à refroidir le premier rouleau en faisant circuler un milieu de refroidissement dans le premier rouleau, et
un mécanisme de communication de mouvement alternatif servant à communiquer un mouvement alternatif, de manière périodique, au troisième rouleau dans une direction axiale par rapport aux premier et deuxième rouleaux.
